(19) Europäisches Patentamt
European Patent Office
Office européen des brevets

(11) EP 0 562 255 B1

(12) **EUROPÄISCHE PATENTSCHRIFT**

(45) Veröffentlichungstag und Bekanntmachung des Hinweises auf die Patenterteilung:
**07.01.1998 Patentblatt 1998/02**

(51) Int Cl.⁶: **H04B 1/02**, H04B 7/22

(21) Anmeldenummer: **93102024.2**

(22) Anmeldetag: **10.02.1993**

(54) **Amplitudenmodulierter Rundfunksender für verschiedene Modulationsarten, insbesondere DSB, SSB und ISB**

AM radio transmitter for various modulations, especially DSB, SSB, ISB

Transmetteur AM pour radio à plusieurs modulations, esp. DSB, SSB, ISB

(84) Benannte Vertragsstaaten:
**DE FR GB**

(30) Priorität: **27.03.1992 DE 4210069**

(43) Veröffentlichungstag der Anmeldung:
**29.09.1993 Patentblatt 1993/39**

(73) Patentinhaber: **THOMCAST AG**
**5300 Turgi (CH)**

(72) Erfinder:
- **Gehri, Patrick**
  **CH-5223 Riniken (CH)**
- **Tomljenovic, Nenad**
  **CH-5415 Nussbaumen (CH)**

(74) Vertreter: **Ottow, Jens M., Dr. et al**
**Hug Interlizenz AG**
**Nordstrasse 31**
**Postfach 127**
**8035 Zürich (CH)**

(56) Entgegenhaltungen:
**EP-A- 0 188 329          EP-A- 0 202 985**

- **SOVIET INVENTIONS ILLUSTRATED, El Sektion, Woche 9138, 6. November 1991 DERWENT PUBLICATIONS LTD., London, W02**
- **SOVIET INVENTIONS ILLUSTRA- TED, El Sektion, Woche 8940, 15. November 1989 DERWENT PUBLICATIONS LTD., London W02**

## Beschreibung

### Technisches Gebiet

Die Erfindung bezieht sich auf das Gebiet der Rundfunk-Sendetechnik. Sie betrifft insbesondere einen amplitudenmodulierten Rundfunksender für verschiedene Modulationsarten, insbesondere DSB (Double Side-Band), SSB (Single Side-Band) und ISB (Independent Side-Band).

Ein Verfahren und eine entsprechende Vorrichtung zur Erzeugung eines ISB-Sendesignals sind aus der US 4,955,072 bekannt.

Ein Verfahren und eine entsprechende Vorrichtung zur Erzeugung eines SSB-Sendesignals sind aus der EP 0,193,655 A1 bekannt.

Verschiedene Verfahren und entsprechende Vorrichtungen zur Erzeugung eines DSB-Sendesignals sind beispielsweise im Buch "Taschenbuch der Hochfrequenztechnik" (H. Meinke und F.W. Gundlach, Springer-Verlag Berlin/Heidelberg/New York 1968) beschrieben.

### Stand der Technik

In der Rundfunk-Sendetechnik, die mit Amplitudenmodulation (AM) arbeitet, werden Sender verwendet, bei denen von den zwei durch die Modulation entstehenden Seitenbänder entweder beide (DSB = Double Side-Band) oder nur eines (SSB = Single Side-Band) übertragen werden. Zusätzlich gibt es noch die Variante, dass die beiden Seitenbänder unabhängig voneinander unterschiedliche Informationen tragen (ISB = Independent Side-Band). Bei den amplitudenmodulierten Rundfunksendern nach dem Stand der Technik werden für die verschiedenen Modulationsarten DSB, SSB und ISB Sender mit je verschiedenen Modulatoren eingesetzt.

Ein Verfahren zur Erzeugung eines amplitudenmodulierten ISB-Sendesignals sowie eine Vorrichtung zur Durchführung des Verfahrens wird in der US 4,955,072 vorgeschlagen. Es basiert auf dem in der EP 0,193,655 A1 offenbarten Einseitenbandmodulationsverfahren und dem entsprechenden Einseitenbandmodulator.

Ein SSB oder ein ISB-Signal ist nicht mehr rein amplitudenmoduliert, sondern zusätzlich noch phasenmoduliert. Es muss also eine Vorrichtung für die benötigte Phasenmodulation zur Verfügung gestellt werden. Die beiden unabhängigen NF-Signale werden beim genannten ISB-Verfahren in ihre orthogonalen Komponenten zerlegt. Aus diesen orthogonalen Komponenten und einer Trägeramplitude werden Komponentensummen gebildet, derart, dass ein Signal entsteht, welches die Information des einen NF-Signals im unteren Seitenband, diejenige des zweiten NF-Signals im oberen enthält. Dieses Signal wird dann einem Amplitudenrechner bzw. einem zyklischen Abtaster zugeführt. Der Amplitudenrechner liefert ein Amplitudensignal, welches nach geeigneter Umsetzung für die Anodenmodulation der Senderöhre verwendet werden kann. Aus den Abtastwerten des Abtasters erhält man durch Klippung oder Nullstellendetektion ein Phasensignal. Dieses Phasensignal wir nach geeigneter Frequenzumsetzung für die Gittermodulation der Senderöhre verwendet. Es moduliert also die Trägerschwingung des Sendesignals.

Beim genannten SSB-Verfahren und der entsprechenden Vorrichtung wird auf ähnliche Weise aus einem NF-Signal ein phasenunabhängiges Amplitudensignal und ein amplitudenunabhängiges Phasensignal erzeugt.

Diesen verschiedenen Verfahren und Vorrichtungen ist jedoch gemeinsam, dass sie jeweils für nur eine Modulationsart eingesetzt werden können.

### Darstellung der Erfindung

Aufgabe der vorliegenden Erfindung ist es nun, einen Rundfunksender anzugeben, der mit demselben Modulator für alle drei Modulationsarten (DSB, SSB und ISB) eingesetzt werden kann.

Diese Aufgabe wird beim erfindungsgemässen, amplitudenmodulierten Rundfunksender, welcher umfasst

a) einen Signaleingang für mindestens ein zu übertragendes NF-Signal;

b) eine Signalaufbereitung mit wenigstens einem Eingangskanal und zwei Ausgängen, wobei der Eingang der Signalaufbereitung mit dem Signaleingang in Verbindung steht, und am ersten Ausgang der Signalaufbereitung ein Amplitudensignal, und am zweiten Ausgang ein Phasensignal abgegeben wird;

c) einen hinter dem ersten Ausgang angeordneten gleichspannungsgekoppelten Leistungsverstärker zur Verstärkung des Amplitudensignals;

d) eine hinter dem zweiten Ausgang angeordnete Phasenaufbereitung zur Verarbeitung des Phasensignals; und

e) eine Endstufe mit einer Senderöhre, welche eine Anode und wenigstens ein Steuergitter aufweist, wobei der Ausgang des Leistungsverstärkers mit der Anode und der Ausgang der Phasenaufbereitung mit dem wenigstens einen Steuergitter verbunden ist;

2

dadurch gelöst, dass zur Realisierung verschiedener Modulationsarten, insbesondere DSB (Double Side-Band), SSB (Single Side-Band) und ISB (Independent Side-Band), mit nur einem Sender

f) die Signalaufbereitung zwei Eingangskanäle aufweist und umfasst

aa) einen Addierer und einen Subtrahierer, welche die Summe bzw. die Differenz der Eingangskanäle bilden;
bb) einen Hilberttransformator, dessen Eingang entweder mit dem Ausgang des Addierers oder des Subtrahierers verbunden ist, und der entweder die Summe oder die Differenz einer Hilberttransformation unterwirft;
cc) zwei Inverter, deren Eingänge mit den Ausgängen entweder des Addierers oder des Subtrahierers sowie des Hilberttransformators verbunden sind und welche Inverter das Vorzeichen der an ihren Eingängen liegenden Signale umkehren;
dd) einen zyklischen Abtaster, welcher die Ausgänge der Inverter und entweder des Addierers oder des Subtrahierers sowie des Hilberttransformators in einer bestimmten Reihenfolge zyklisch abtastet;
ee) einen Phasenrechner, dessen Eingang mit dem Ausgang des zyklischen Abtasters verbunden ist, und dessen Ausgang mit dem Phasenausgang in Verbindung steht, und welcher Phasenrechner aus den Abtastwerten des zyklischen Abtasters ein Phasensignal erzeugt;
ff) einen Amplitudenrechner, welcher mit seinen beiden Eingängen an den Ausgang entweder des Addierers oder des Subtrahierers sowie des Hilberttransformators angeschlossen ist und die Eingangssignale je quadriert, summiert und daraus die Wurzel zieht und dieses Signal an seinen Ausgang gibt, welcher mit dem Amplitudenausgang verbunden ist; und

g) die Modulationsart durch bestimmte Zuordnung der zu übertragenden NF-Signale auf die beiden Eingangskanäle festgelegt wird.

Der erfindungsgemässe Rundfunksender hat den Vorteil, dass er für alle drei Modulationsarten DSB, SSB und ISB einsetzbar ist.
Die Betriebsarten werden gemäss einer bevorzugten Ausführungsform dadurch eingestellt, dass

a) für ISB zwei von einander unabhängige NF-Signale an die zwei Eingangskanäle angeschlossen werden;
b) für DSB zwei gleiche NF-Signale an die zwei Eingangskanäle angeschlossen werden; und
c) für SSB nur an einen Eingangskanal ein NF-Signal angeschlossen wird, während der andere Eingangskanal auf Masse gelegt wird.

Aus der Gesamtheit der abhängigen Ansprüche ergeben sich weitere vorteilhafte Ausführungsformen.
Der Kern der Erfindung besteht darin, dass beim erfindungsgemässen Rundfunksender alle drei Modulationsarten DSB, SSB und ISB dadurch eingestellt werden können, dass für DSB die zwei NF-Signal-Eingänge entweder zusammengeschaltet werden, bzw. das gleiche Signal eingespiesen wird, für SSB nur an einen Eingang ein Signal angelegt wird, während der andere auf Masse gelegt wird, und für ISB zwei voneinander unabhängige Signale an die beiden NF-Signal-Eingänge gelegt werden. Der erfindungsgemässe Rundfunksender ist also universell einsetzbar und die Betriebsart kann durch eine Zuordnung der NF-Signale auf die Eingangskanäle eingestellt werden.

**Kurze Beschreibung der Zeichnungen**

Nachfolgend soll die Erfindung anhand von Ausfuhrungsbeispielen im Zusammenhang mit den Zeichnungen näher erläutert werden.
Es zeigen:

Fig. 1      ein Blockschaltbild eines erfindungsgemässen Rundfunksenders,

Fig. 2      ein Blockschaltbild einer erfindungsgemässen Signalaufbereitung,

Fig. 3a      ein Zeigerdiagramm eines ISB-Signals

Fig. 3b      ein Zeigerdiagramm eines DSB-Signals

Fig. 3c      ein Zeigerdiagramm eines SSB-Signals

Fig. 4      ein Blockschaltbild einer bevorzugten Ausführungsform einer erfindungsgemässen Signalaufbereitung

EP 0 562 255 B1

Fig. 5a      die Abtastung eines cosinusförmigen Signals,

Fig. 5b      die Abtastung eines sinusförmigen Signals,

Fig. 6      die Abtastung eines cosinusförmigen Signals, das sprunghaft um eine Winkel $\Phi$ verschoben worden ist (PSK),

Fig. 7      den 180°-Phasensprung, der auftritt, falls die Signalamplitude grösser als die Trägeramplitude wird.

Die in den Zeichnungen verwendeten Bezugzeichen und deren Bedeutung sind in der Bezeichnungsliste zusammengefasst aufgelistet. Grundsätzlich sind in den Figuren gleiche Teile mit gleichen Bezugzeichen versehen.

**Wege zur Ausführung der Erfindung**

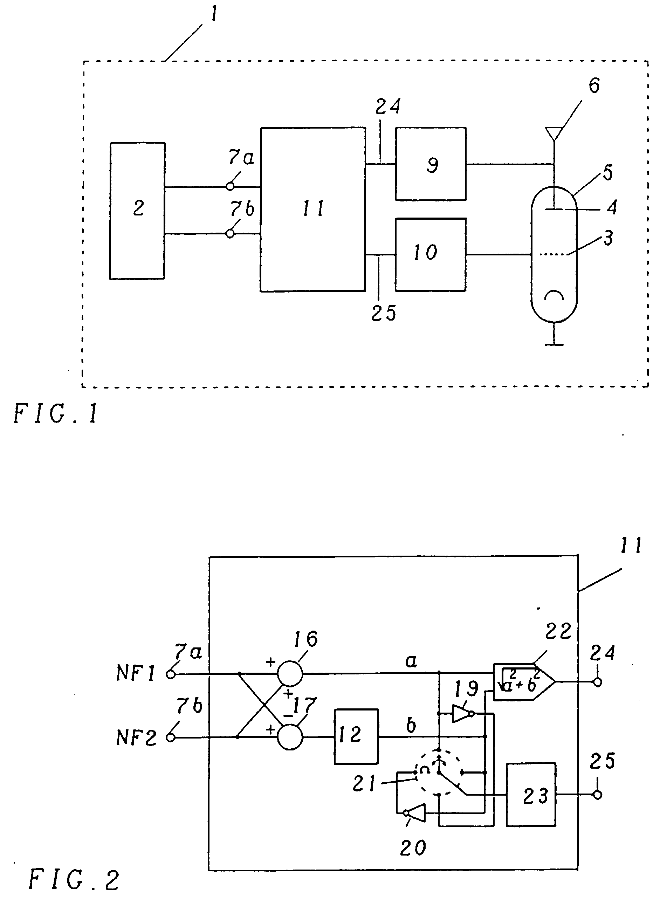

In Figur 1 ist das Blockschaltbild eines erfindungsgemässen amplitudenmodulierten Rundfunksenders (1) für verschiedene Modulationsarten, insbesondere DSB, SSB und ISB, dargestellt.

Der Rundfunksender (1) umfasst einen Signaleingang (2), eine Signalaufbereitung (11), einen gleichspannungsgekoppelten Leistungsverstärker (9), eine Phasenaufbereitung (10) und eine Senderöhre (5). Der Signaleingang (2) ist für mindestens ein zu übertragenes Signal ausgelegt und steht mit den zwei Eingangskanälen (7a, 7b) der Signalaufbereitung (11) in Verbindung. In der Signalaufbereitung (11) werden nach Massgabe der NF-Signale (NF1, NF2), die an den Eingangskanälen (7a, 7b) anliegen, ein Amplitudensignal und ein Phasensignal erzeugt, welche am Amplituden- bzw. Phasenausgang (24, 25) der Signalaufbereitung (11) zur Verfügung stehen.

Das Amplitudensignal wird in einem hinter dem Amplitudenausgang (24) angeordneten gleichspannungsgekoppelten Leistungsverstärker (9) verstärkt und als anodenmodulierendes Signal auf die Anode (4) der Senderöhre (5) gegeben. Der gleichspannungsgekoppelte Leistungsverstärker (9) umfasst bevorzugterweise einen Puls-Stufen-Verstärker (PSM-Verstärker). Andere Verstärkungsarten, z.B. Gegentakt-B-Verstärker, sind jedoch auch denkbar.

Das Phasensignal wird in einer hinter dem Phasenausgang (25) angeordneten Phasenaufbereitung (10) auf die zur Gittermodulation erforderliche Form gebracht. Der Ausgang der Phasenaufbereitung (10) ist mit dem wenigstens einen Steuergitter (3) der Senderöhre (5) verbunden.

Die Phasenaufbereitung (10) umfasst im wesentlichen einen Frequenzumsetzer, der das Phasensignal auf die benötigte Trägerfrequenz heraufsetzt.

Anhand der Figuren 2, 3a-c, 5a und 5b soll die Funktionsweise der zum erfindungsgemässen Rundfunksender gehörenden Signalaufbereitung (11) erklärt werden.

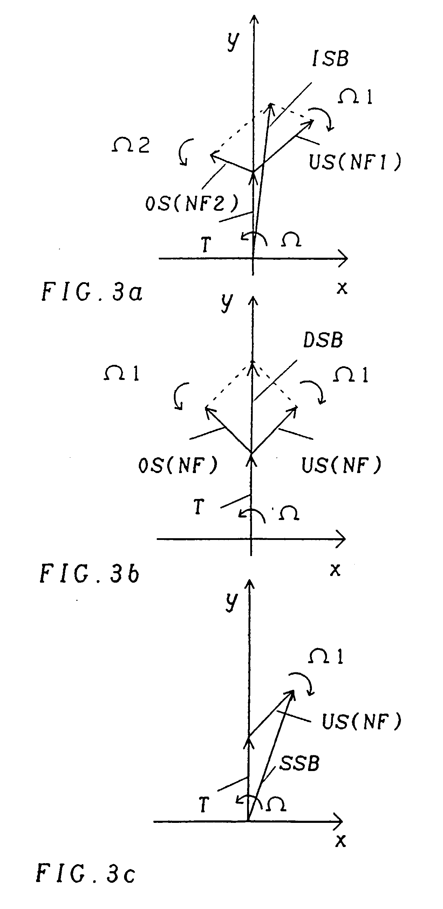

Figur 3a zeigt das Zeigerdiagramm eines ISB-Signals. Deutlich zu sehen ist, wie der resultierende Vektor ISB aus einem Träger T und zwei NF-Signalen, dargestellt als die Vektoren NF1 und NF2, zusammengesetzt ist. Die Vektoren NF1 und NF2 rotieren mit der Frequenz $\Omega 1$ bzw. $\Omega 2$. Im Frequenzbereich stellt NF1 das obere Seitenband und NF2 das untere Seitenband dar. Vergleicht man die Figuren 3b und 3c mit der Figur 3a , so wird klar, dass ein ISB-Signal das allgemeinste amplitudenmodulierte Signal mit zwei Seitenbändern darstellt. Bei einem DSB-Signal sind nämlich die beiden Signale NF1 bzw. NF2 gleich, bei einem SSB-Signal ist nur ein Signal vorhanden. Die Erklärung der Erfindung kann also ohne Beschränkung der Allgemeinheit anhand eines ISB-Signals vorgenommen werden, um am Schluss die Einschränkung auf die Spezialfälle DSB bzw. SSB auszuführen.

Ein ISB-Signal besteht, wie schon erläutert, aus einen Träger T, der, dargestellt als Vektor, in der Ebene mit der Kreisfrequenz $\Omega$ rotiert und der Summe von zwei Vektoren NF1 und NF2, die gegenläufig zueinander rotieren ($\Omega 1$ bzw. $\Omega 2$). NF1 stellt somit das untere Seitenband dar, NF2 das obere. Die gegenläufige Rotation wird dadurch erreicht, dass ein Vektor, im vorliegenden Falle NF1, um -90° phasenverschoben wird. Die -90°-Phasenverschiebung wird dadurch erreicht, dass bei der Summation NF1 für das untere Seitenband um - 180°, bzw. 180° verschoben wird, was einer Umkehr des Vorzeichens entspricht (Subtraktion). Anschliessend wird die Summe, welche dem oberen Seitenband entspricht, gegenüber der erhaltenen Differenz um 90° verschoben. Am Schluss resultiert also eine totale Verschiebung um -90°. Die 90°-Phasenverschiebung der Summe gegenüber der Differenz wird vorzugsweise in einem Hilberttransformator durchgeführt. Wichtig ist dabei nicht die absolute Phasenverschiebung zwischen der Summe bzw. der Differenz, sondern die relative. Da die Hilberttransformation eine lineare Transformation ist, kann diese auch vor der Summen- bzw. Differenzbildung vorgenommen werden.

Nach den oben genannten Operationen, Summation, Subtraktion und Hilberttransformation steht also, um auf die Zeigerdiagrammdarstellung zurückzukommen, der Vektor ISB zur Verfügung. Er muss jetzt nur noch so in Rotation gesetzt werden, damit er die Information des ersten NF-Signals (NF1) im unteren Seitenband, diejenige des zweiten NF-Signals (NF2) im oberen trägt. Ein Vektor ist allgemein entweder durch seine Komponenten oder durch Betrag und Phase vollständig definiert. Zur Uebertragung der vollständigen Information genügt es also, wenn Amplitude und Phase übertragen werden.

4

Die Berechnung des Betrages lässt sich auf einfache Weise durch einzelnes Quadrieren der orthogonalen Komponenten und Summation dieser Quadrate mit anschliessender Wurzelziehung berechnen. Die orthogonalen Komponenten entsprechen dabei dem Ausgang des Hilberttransformators (12) und a dem Ausgang des Addierers und b dem Ausgang des Subtrahierers. Die Signale a bzw. b stehen nämlich orthogonal zueinander (-90°-Phasenverschiebung). Damit steht das Amplitudensignal zur Verfügung.

Für die Bestimmung der Phase wird der folgende Weg beschritten:

Um ein vollständiges ISB-Signal zu erhalten, muss der Vektor ISB zusätzlich in eine Rotation mit der Kreisfrequenz $\Omega$ versetzt werden. Dies erreicht man dadurch, dass der Vektor in einer vorgeschriebenen Reihenfolge zyklisch abgetastet wird. Ein mit einer Kreisfrequenz $\Omega$ im Gegenuhrzeigersinn rotierender Vektor ISB kann dadurch nachgebildet werden, dass seine Komponenten a bzw. b in der Reihenfolge a, -b,-a, b, a, -b ... zyklisch abgetastet werden. Für eine Rotation im Uhrzeigersinn ergibt sich eine Abtastung in der Reihenfolge a, b, -a, -b, a, b ... Eine Sequenz der Art a, b, -a, -b, a, b ... kann auch als Summe der Sequenzen a, 0, -a, 0, a, 0 ... und 0, b, 0, -b, 0, b ... dargestellt werden.

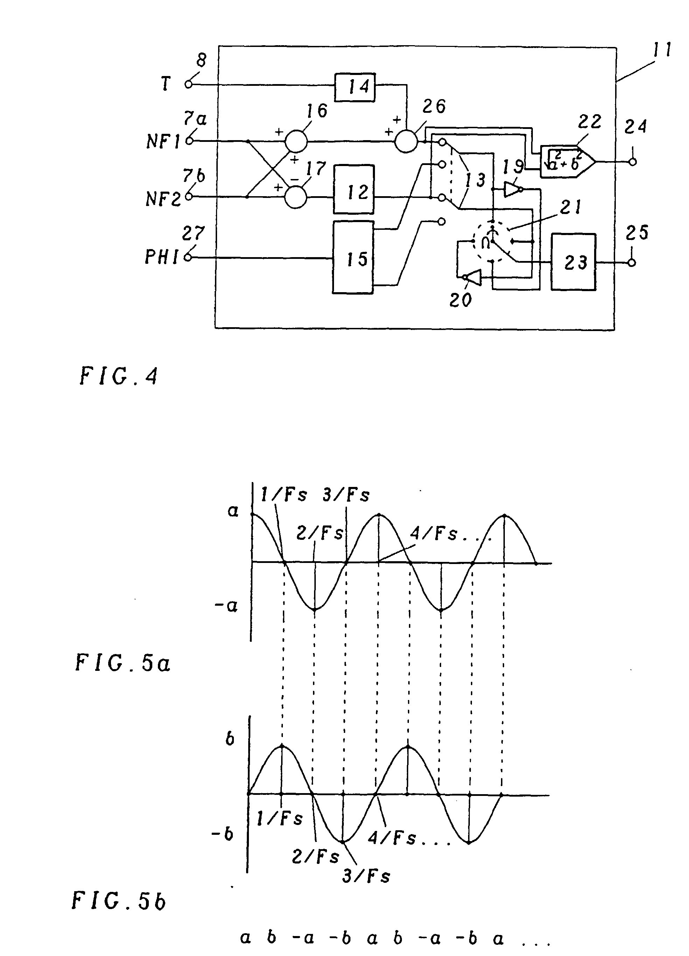

Wie die Figuren 5a und 5b zeigen, entspricht eine Sequenz der Art a, 0, -a, 0, a, 0 ... bzw. 0, b, 0, -b, 0, b ... der Abtastung eines cosinusförmigen Signals mit der Frequenz Fs/4 und der Amplitude a bzw. der Abtastung eines sinusförmigen Signals mit derselben Frequenz und der Amplitude b. Die zyklische Abtastung des Summen- bzw. des Differenzsignals entspricht also einer Multiplikation mit einem cos- bzw. einem sin-Signal mit der Frequenz $\Omega$=Fs/4. Da sich der Vektor ISB aus der Trägeramplitude T und den rotierenden Vektoren NF1 und NF2 zusammensetzt, ändert sich die Phase des entstehenden Signals in gleichem Masse wie die beiden Vektoren NF1 und NF2.

Die Phaseninformation muss nun noch auf eine besondere Art und Weise gewonnen werden. Ziel ist es dabei, ein harmonisches Phasensignal der Form $\cos(\Omega t + \Phi(t))$ zu erhalten.

Im Normalfall wird die Abtastfrequenz $\Omega$ viel grösser als die Grenzfrequenzen der NF-Signale NF1 und NF2 sein. Das heisst, die Nulldurchgänge der o.g. cos-Funktion wird fast gleich den Nulldurchgängen der Abtastwerte, die beim erwähnten zyklischen Abtasten der Komponenten a bzw. b entstehen. Durch eine Nulldurchgangsbestimmung und der Erzeugung eines entsprechenden Rechtecksignals sowie geeigneter Filterung kann also die gewünschte cos-Funktion erhalten werden. Das Phasensignal muss nur noch auf die gewünschte Trägerfrequenz umgesetzt werden. Durch Multiplikation in der Röhre mit dem Amplitudensignal A(t) erhält man schliesslich das gewünschte ISB-Signal.

Im erfindungsgemässen Rundfunksender werden also folgende Schritte ausgeführt:

- Addition und Subtraktion der Signale NF1 bzw. NF2,
- Hilberttransformation entweder der Summe oder der Differenz,
- Betragsbildung für das Amplitudensignal,
- zyklische Abtastung und Nullstellendetektion für das Phasensignal.

Mathematisch werden folgende Schritte ausgeführt:

Im folgenden bedeutet das Zeichen "^" die Operation der Hilberttransformation.

Ausgegangen wird von zwei sinusförmigen Signalen:

$NF1(t) = A\cos w_1 t$ bzw. $NF2(t) = B\cos w_2 t$

Diese werden summiert bzw. subtrahiert und die Differenz einer Hilberttransformation unterworfen. Die entstehenden Signale werden so abgetastet, dass die hilberttransformierte Summe mit coswt multipliziert wird und die Differenz mit sinwt multipliziert wird (siehe Figur 5a,b).

$$
\begin{aligned}
y(t) &= [NF1(t) + NF2(t)]\cos wt + [\widehat{NF2(t) - NF1(t)}]\sin wt \\
&= [A\cos w_1 t + B\cos w_2 t]\cos wt + [\widehat{B\cos w_2 t - A\cos w_1 t}]\sin wt \\
&= [A\cos w_1 t + B\cos w_2 t]\cos wt + [B\sin w_2 t - A\sin w_1 t]\sin wt \\
&= A\cos[(w + w_1)t] + B\cos[(w - w_2)t]
\end{aligned}
$$

Das Signal NF1 bildet also das obere Seitenband $(w + w_1)$, das Signal NF2 das untere $(w - w_2)$.

Nach dieser Erklärung können nun in der Figur 2 die einzelnen Teile leicht identifiziert werden.

Es sind zwei Eingangskanäle (7a und 7b) vorhanden, an denen die beiden Signal NF1 und NF2 angeschlossen werden. Im Addierer (16) wird die Summe der Signale NF1 und NF2 gebildet, im Subtrahierer (17) die Differenz. Die Differenz wird im Hilberttransformator (12) gegenüber der Summe um 90° phasenverschoben. Selbstverständlich kann der Hilberttransformator anstatt nach dem Subtrahierer auch nach dem Addierer angeordnet sein. Summe a und hilberttransformierte Differenz b werden dem Amplitudenrechner (22) zugeführt, welcher den Betrag der beiden Eingangssignale bildet und an den Amplitudenausgang (24) weitergibt. Die Summe a und die hilberttransformierte Differenz b werden in den beiden Invertern (19 und 20) invertiert. Die Differenz b und die hilberttransformierte Summe a sowie ihre jeweiligen Inversen sind mit den Eingängen des zyklischen Abtasters (21) verbunden. Im Phasenrechner (23) wird durch Nullstellendetektion bzw, Klippung aus den Abtastwerten das Phasensignal berechnet und an den Phasenausgang (25) gegeben. Amplitudenausgang (24) bzw. Phasenausgang (25) stehen mit dem gleichspannungsgekoppelten Verstärker (9) bzw. der Phasenaufbereitung (10) in Verbindung.

Auf die tatsächliche Ausführung des Hilberttransformators, des Amplitudenrechners, des Phasenrechners und des zyklischen Abtasters wird hier nicht näher eingegangen, da diese bereits aus den eingangs erwähnten Patentschriften bekannt sind.

Ein Vergleich der Figuren 3a-c zeigt, dass ein DSB-Signal als ein ISB-Signal, bei dem beide NF-Signale gleich sind, interpretiert werden kann und dass ein SSB-Signal nichts anderes ist als ein ISB-Signal mit nur einen NF-Signal.

Die eben vorgestellte Signalaufbereitung (11) lässt sich also für alle drei Modulationsarten ISB, DSB und SSB einsetzen, indem die Eingangskanäle (7a,b) wie folgt zu den NF-Signalen zugeordnet werden:

ISB: $NF1(t) \neq NF2(t) \neq 0$
DSB: $NF1(t) = NF2(t) = NF(t)$
SSB: $NF1(t) = NF(t)$ und $NF2(t) = 0$

Schaltungstechnisch lässt sich das dadurch erreichen, dass

a) für ISB zwei verschiedene, voneinander unabhängige Signale NF1(t) und NF2(t) an die beiden Eingangskanäle angeschlossen werden,
b) für DSB die zwei Eingangskanäle zusammengeschlossen werden und nur ein Signal angeschlossen wird,
c) für SSB ein Eingangskanal auf Masse gelegt wird, während beim anderen ein NF-Signal angeschlossen wird.

Bis jetzt war immer von Signalen ohne Träger die Rede. Die erhaltenen Signale waren also alles solche mit unterdrücktem Träger. Selbstverständlich kann bei der erfindungsgemässen Signalaufbereitung aber auch ein Träger dazu addiert werden.

Figur 4 zeigt den zusätzlichen Addierer (26), der nach der Hilberttransformation im Summenkanal dazwischengeschaltet wird.

In folgender Rechnung wird der Träger zu den beiden Signalen NF1(t) bzw. NF2(t) addiert:

$$y(t) = \overline{[NF2(t) - NF1(t)]}\sin wt + \{T + [NF1(t) + NF2(t)]\}\cos wt$$
$$= \overline{[B\cos w_2 t - A\cos w_1 t]}\sin wt + \{T + [A\cos w_1 t + B\cos w_2 t]\}\cos wt$$
$$= [B\sin w_2 t - A\sin w_1 t]\sin wt + \{T + [A\cos w_1 t + B\cos w_2 t]\}\cos wt$$
$$= T\cos wt + A\cos[(w + w_1)t] + B\cos[(w - w_2)t]$$

Die Addition eines Trägers ist einerseits für die Demodulation von grosser Bedeutung. Auf der anderen Seite wird dadurch aber ein grosser Teile der Senderleistung für den Träger verwendet. Um den Anteil der Signalleistung gegenüber der Trägerleistung zu verbessern, kann beim erfindungsgemässen Rundfunksender der Träger T in Abhängigkeit des Modulationsgrades gesteuert werden.

Der Träger (T) wird an den zusätzlichen Eingang (8) angeschlossen. Die Steuerung nach Massgabe der Trägersteuerungskennlinie bzw. die Unterdrückung wird in der Trägersteuerung (14) vorgenommen. Wird der Träger nur so weit gesenkt, dass die Trägeramplitude immer grösser als Signalamplitude ist, spricht man von Dynamic Carrier Control (DCC). Wird der Träger noch weiter gesenkt, kann der Fall auftreten, dass die Signalamplitude grösser als der Träger wird. Dadurch klappt der Vektor bildlich gesprochen nach unten. Bei einem sinusförmigen Signal tritt ein 180°-Phasensprung auf.

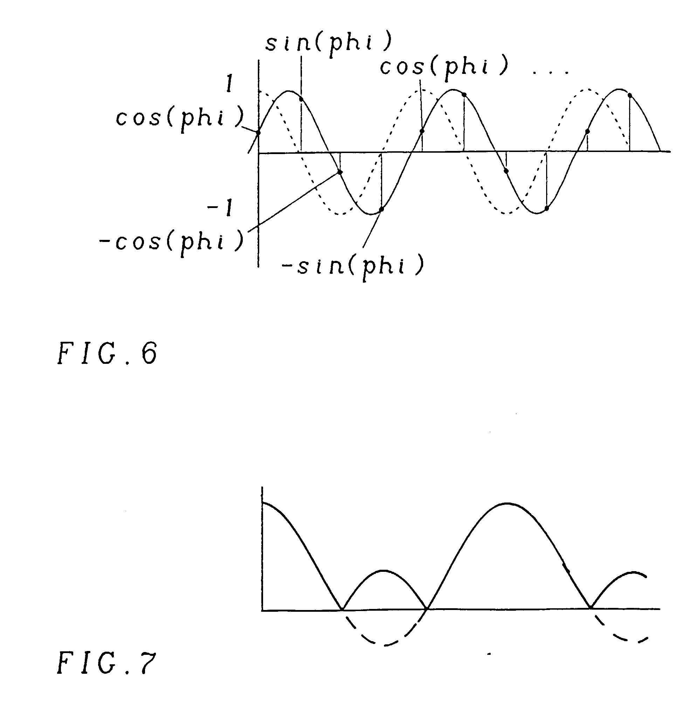

Figur 7 zeigt die Auswirkung eines solchen 180°-Phasensprungs auf ein sinusförmiges Signal.

Durch diesen 180°-Phasensprung erhält das Signal zusätzlich noch einen phasenmodulierten Teil. Dieser Effekt tritt sowohl bei Signalen ohne Träger als auch bei Signalen, bei denen die Trägeramplitude gesteuert wird, dann auf, wenn die Summe der Seitenlinienvektoren grösser als der Trägervektor wird. Eine solche zusätzliche Phasenmodulation wurde bis jetzt wenn möglich vermieden, da durch den Phasensprung einerseits der Klirrfaktor grösser wird und andererseits die Beanspruchung der Senderöhre ansteigt.

Ein Zweiseitenbandsignal mit unterdrücktem Träger (Double Side Band with Supressed Carrier, DSBSC) weist, im Gegensatz zu einem Zweiseitenbandsignal (DSB), folgende Form auf:

DSB: $x_{DSB}(t) = A(t)*\cos(w_0 t)$
mit $\quad A(t) = (T + m*s_{NF}(t)) >= 0 \qquad$ Amplitude
DSBSC: $x_{DSBSC}(t) = A(t)*\cos(w_0 t + \Phi(t))$
mit $\quad A(t) = \text{abs}(T + m*S_{NF}(t)) >= 0 \qquad$ Amplitude
und $\quad \Phi(t) = (\pi/2)*(1-\text{sign}(A(t))) \qquad$ Phase
$\qquad T = \quad$ Träger
$\qquad s_{NF} = \quad$ NF-Signal
$\qquad m = \quad$ Signalamplitude/Trägeramplitude (Modulationsgrad)

$x_{DSBSC}(t)$ weist also, mathematisch gesehen, die gleiche Form wie das allgemeinste amplitudenmodulierte Signal, das ISB-Signal, auf. Ein solches, sowohl amplituden-, wie auch phasenmoduliertes, Signal kann auf die gleiche Art wie ein ISB-Signal in der Signalaufbereitung (11) des erfindungsgemässen Rundfunksenders (1) verarbeitet werden, indem das Amplitudensignal im Amplitudenrechner (22) und das Phasensignal im Phasenrechner (23) gebildet werden.

Das Amplitudensignal A(t) entspricht demjenigen des DSB-Signals mit Träger. Das Phasensignal ergibt sich auf die gleiche Art und Weise wie beim ISB-Signal durch die zyklische Abtastung der Komponentensummen mit nachfolgender Nullstellendetektion oder Klippung.

Der erfindungsgemässe Rundfunksender erlaubt also nicht nur die Uebertragung von ISB, SSB und DSB-Signalen, sondern auch die Uebertragung von solchen Signalen mit unterdrücktem oder gesteuertem Träger. Bei DSB-Signalen darf der Träger so weit gesenkt werden, dass die Signalamplitude grösser als die Trägeramplitude wird, da die durch den 180°-Phasensprung bedingte zusätzliche Phasenmodulation im zyklischen Abtaster vorgenommen wird. Durch die Unterdrückung oder die Steuerung des Trägers kann die Ausnützung der Sendeleistung wesentlich verbessert werden.

Es stellt sich nun die Frage, was mit dem zyklischen Abtaster und dem Phasenrechner geschieht, falls der Träger weder unterdrückt noch gesteuert wird, das DSB-Signal also rein amplitudenmoduliert ist.

Zyklischer Abtaster und Phasenrechner stellen eine Einrichtung zur Phasenmodulation einer Trägerschwingung dar. Diese Einrichtung kann als Möglichkeit, eine zusätzliche Information mittels beliebiger Phasenmodulation der Trägerschwingung zu übertragen, auch bei DSB-Signalen mit vollem Träger eingesetzt werden. Denkbar ist beispielsweise die Uebertragung einer Sendererkennung mittels Phasenumtastung (Phase Shift Keying, PSK) der Trägerschwingung. Beim PSK-Verfahren wird eine Information übertragen, indem die Phase einer Trägerschwingung sprunghaft geändert wird. Im Zusammenhang mit den Figuren 5a und 5b wurde gezeigt, wie nach dem Prinzip der zyklischen Abtastung eine Trägerfrequenz von Fs/4 erzeugt werden kann: Im Normalfall werden die Abtastzeitpunkte so gelegt, dass jeder zweite Wert Null beträgt. Die Abtastwerte weisen dann im normierten Fall die Werte 1, 0, -1, 0 etc. auf. Diese Sequenz entspricht einer mit Fs abgetasteten Cosinus-Schwingung der Frequenz Fs/4. Dieses Signal soll nun sprunghaft um einen Winkel $\Phi$ phasenverschoben werden. Figur 6 zeigt wie das phasenverschobene, ausgezogene Signal aus dem ursprünglichen, gestrichelten Signal hervorgeht. Für ein phasenverschobenes Trägersignal ergibt sich natürlich eine andere Sequenz von Abtastwerten. Nachfolgende Tabelle zeigt die Sequenzen für eine Trägerschwingung mit den Phasenlagen 0°, $\Phi$ und -$\Phi$.

| $\Phi$ | Abtastsequenz | | | | |
|---|---|---|---|---|---|
| 0° | 1 | 0 | -1 | 0 | etc. |
| $\Phi$ | $\cos\Phi$ | $\sin\Phi$ | $-\cos\Phi$ | $-\sin\Phi$ | etc. |
| -$\Phi$ | $\cos\Phi$ | $-\sin\Phi$ | $-\cos\Phi$ | $\sin\Phi$ | etc. |

Durch die Wahl von geeigneten Abtastsequenzen kann also die Trägerschwingung einer beliebigen Phasenumtastung unterworfen werden. Damit kann eine zusätzliche Information übertragen werden.

Bei der Signalaufbereitung (11) gemäss Figur 4 können an der Stelle der Ausgänge des Addierers (26) und des Subtrahierers (17) mittels eines Umschalters (13) die Ausgänge einer Phasenmodulations-Aufbereitung (15) mit den Eingängen des zyklischen Abtasters (21) zusammengeschaltet werden. Die Phasenmodulations-Aufbereitung (15) übernimmt dabei die Aufgabe der Anpassung des phasenmodulierenden Signals (PHI), das an den zusätzlichen Eingang (27) angeschlossen wird, an die Erfordernisse des zyklischen Abtasters (21).

Insgesamt ergibt sich mit der Erfindung ein Rundfunksender, der, aufgrund seines speziellen Aufbaus, folgende Vorteile aufweist:

- Einsatzmöglichkeit sowohl für ISB, DSB und SSB-Signale,
- Einfache Einstellung der Modulationsart durch Zuordnung der zu übertragenden Signale auf die Eingangskanäle,
- Uebertragung von Signalen mit gesteuertem oder unterdrücktem Träger
- Uebertragung von zusätzlicher Information bei DSB-Signalen durch Phasenmodulation der Trägerschwingung.

**Bezeichnungsliste**

| | |
|---|---|
| 1 | Rundfunksender |
| 2 | Signaleingang |
| 3 | Steuergitter |
| 4 | Anode |
| 5 | Senderöhre |
| 6 | Antenne |
| 7a | Eingangskanal 1 |
| 7b | Eingangskanal 2 |
| 8 | Träger-Eingang |
| 9 | gleichspannungsgekoppelter Leistungsverstärker |
| 10 | Phasenaufbereitung |
| 11 | Signal aufbereitung |
| 12 | Hilberttransformator |
| 13 | Umschalter |
| 14 | Träger-Steuerung |
| 15 | Phasenmodulations-Aufbereitung |
| 16 | Addierer 1 |
| 17 | Subtrahierer |
| 19 | Inverter 1 |
| 20 | Inverter 2 |
| 21 | zyklischer Abtaster |
| 22 | Amplitudenrechner |
| 23 | Phasenrechner |
| 24 | Amplituden-Ausgang |
| 25 | Phasen-Ausgang |
| 26 | Addierer 2 |
| 27 | Phasenmodulations-Eingang |
| $\Omega$ | Abtastfrequenz |
| $\Omega 1$ | Frequenz des ersten NF-Signals |
| $\Omega 2$ | Frequenz des zweiten NF-Signals |
| T | Träger |
| NF | NF-Signal |
| NF1 | NF-Signal 1 |
| NF2 | NF-Signal 2 |
| ISB | ISB-Vektor |
| DSB | DSB-Vektor |
| SSB | SSB-Vektor |
| OS | oberes Seitenband |
| US | unteres Seitenband |
| Fs | Abtastfrequenz |
| PHI | Phasenmodulations-Signal |
| a | hilberttransformierte Summe |
| b | Differenz |

**Patentansprüche**

1. Amplitudenmodulierter Rundfunksender (1), umfassend

a) einen Signaleingang (2) für mindestens ein zu übertragendes NF-Signal;
b) eine Signalaufbereitung (11) mit wenigstens einem Eingangskanal und zwei Ausgängen, wobei der Eingang der Signalaufbereitung mit dem Signaleingang in Verbindung steht, und am ersten Ausgang (24) der Signalaufbereitung ein Amplitudensignal, und am zweiten Ausgang (25) ein Phasensignal abgegeben wird;
c) einen hinter dem ersten Ausgang angeordneten gleichspannungsgekoppelten Leistungsverstärker (9) zur Verstärkung des Amplitudensignals;
d) eine hinter dem zweiten Ausgang angeordnete Phasenaufbereitung (10) zur Verarbeitung des Phasensignals; und
e) eine Endstufe mit einer Senderöhre (5), welche eine Anode (4) und wenigstens ein Steuergitter (3) aufweist, wobei der Ausgang des Leistungsverstärkers mit der Anode (4) und der Ausgang der Phasenaufbereitung mit dem wenigstens einen Steuergitter (3) verbunden ist;

dadurch gekennzeichnet, dass zur Realisierung verschiedener Modulationsarten, insbesondere DSB (Double Side-Band), SSB (Single Side-Band) und ISB (Independent Side-Band), mir nur einem Sender

f) die Signalaufbereitung (11) zwei Eingangskanäle (7a,b) aufweist und umfasst

aa) einen Addierer (16) und einen Subtrahierer (17), welche die Summe bzw. die Differenz der Eingangskanäle (7a,b) bilden;
bb) einen Hilberttransformator (12), dessen Eingang entweder mit dem Ausgang des Addierers (16) oder des Subtrahierers (17) verbunden ist, und der entweder die Summe oder die Differenz einer Hilberttransformation unterwirft;
cc) zwei Inverter (19, 20), deren Eingänge mit den Ausgängen (a, b) entweder des Addierers (16) oder des Subtrahierers (17) sowie des Hilberttransformators (12) verbunden sind und welche Inverter (19, 20) das Vorzeichen der an ihren Eingängen liegenden Signale umkehren;
dd) einen zyklischen Abtaster (21), welcher die Ausgänge der Inverter (91, 20) und entweder des Addierers (16) oder des Subtrahierers (17) sowie des Hilberttransformators (12) in einer bestimmten Reihenfolge zyklisch abtastet;
ee) einen Phasenrechner (23), welcher aus den Abtastwerten des zyklischen Abtasters (21) ein Phasensignal erzeugt, dessen Eingang mit dem Ausgang des zyklischen Abtasters verbunden ist, und dessen Ausgang mit dem Phasenausgang (25) in Verbindung steht;
ff) einen Amplitudenrechner (22), welcher mit seinen beiden Eingängen an den Ausgang entweder des Addierers (16) oder des Subtrahierers (17) sowie des Hilberttransformators (12) angeschlossen ist und die Eingangssignale (a, b) je quadriert, summiert und daraus die Wurzel zieht und dieses Signal an seinen Ausgang gibt, welcher mit dem Amplitudenausgang (24) verbunden ist; und

g) die Modulationsart durch bestimmte Zuordnung der zu übertragenden NF-Signale (NF1, NF2) auf die beiden Eingangskanäle (7a, 7b) festgelegt wird.

2. Rundfunksender nach Anspruch 1, dadurch gekennzeichnet, dass

a) für ISB zwei von einander unabhängige NF-Signale (NF1, NF2) an die zwei Eingangskanäle (7a,b) angeschlossen werden;
b) für DSB zwei gleiche NF-Signale an die zwei Eingangskanäle (7a,b) angeschlossen werden; und
c) für SSB nur an einen Eingangskanal (z.B. 7a) ein NF-Signal angeschlossen wird, während der andere Eingangskanal (entspr. 7b) auf Masse gelegt wird.

3. Rundfunksender nach Anspruch 2, dadurch gekennzeichnet, dass die Eingänge (±a, ±b) des zyklischen Abtasters (21) in der Reihenfolge a, b, -a, -b oder a, -b, -a, b abgetastet werden.

4. Rundfunksender nach Anspruch 3, dadurch gekennzeichnet, dass die Signalaufbereitung (11) zusätzlich umfasst

a) einen Träger-Eingang (8),
b) einen zweiter Addierer (26), dessen erster Eingang mit dem Ausgang des Addierers (16) in Verbindung steht und dessen Ausgang mit dem zyklischen Abtaster (21) und dem Amplitudenrechner (22) verbunden ist, und

c) eine Trägersteuerung, deren Eingang mit dem Träger-Eingang (8) verbunden ist und deren Ausgang mit dem zweiten Eingang des Addierers (26) in Verbindung steht, wobei

d) der Träger (T) nach dem Addierer (16) mittels des zweiten Addierers (26) addiert wird.

5. Rundfunksender nach Anspruch 4, dadurch gekennzeichnet, dass der addierte Träger (T) in der Trägersteuerung (14) nach Massgabe einer Trägersteuerungskennlinie in Abhängigkeit vom Modulationsgrad gesteuert wird.

6. Rundfunksender nach einem der vorangegangenen Ansprüche, dadurch gekennzeichnet, dass die Signalverarbeitung (11) zusätzlich umfasst

a) einen vierpoliger Umschalter (13), wobei immer zwei Eingänge zu einem Eingangspaar gekoppelt sind, und das erste Eingangspaar mit dem Ausgang des Hilberttransformators (12) bzw. des Addierers (16) verbunden ist, und dessen Ausgänge mit den Eingängen des zyklischen Abtasters (21) verbunden sind;

b) einen Eingangskanal (27) für ein weiteres Signal (PHI);

c) eine Phasenmodulations-Aufbereitung (15), deren Eingang mit dem zusätzlichen Eingangskanal (27) verbunden ist, und deren Ausgänge mit dem zweiten Eingangspaar des Umschalters (13) in Verbindung stehen.

7. Rundfunksender nach Anspruch 6, dadurch gekennzeichnet, dass bei DSB, unter der Voraussetzung, dass die Signalamplitude immer kleiner als der Träger ist, zur Uebertragung einer zusätzlichen Information

a) der Umschalter (13) so geschaltet wird, dass die Ausgänge der Phasenmodulations-Aufbereitung (15) auf den zyklischen Abtaster durchgeschaltet sind und

b) das im zyklischen Abtaster entstehende Phasensignal durch die Phasenmodulations-Aufbereitung phasenmoduliert wird.

8. Rundfunksender nach Anspruch 7, dadurch gekennzeichnet, dass die Eingangssignale des zyklischen Abtasters (21) zur Erzeugung einer sprunghaften Phasenverschiebung eines phasenumtasteten Signals um den Winkel $\Phi$ zu den Zeitpunkten t1, t2, t3, t4 abgetastet werden, an denen die Abtastwerte

bei t1: $\cos\Phi$,
bei t2: $\sin\Phi$,
bei t3: $-\cos\Phi$,
bei t4: $-\sin\Phi$

betragen.

9. Rundfunksender nach einem der vorangegangenen Ansprüche, dadurch gekennzeichnet, dass die Reihenfolge des Addierers (16) bzw. des Subtrahierers (17) und des Hilberttransformators (12) vertauscht sind, wobei für jeden Eingangskanal ein eigener Hilberttransformator vorgesehen ist.

10. Rundfunksender nach einem der vorangegangenen Ansprüche, dadurch gekennzeichnet, dass der gleichspannungsgekoppelte Leistungsverstärker (9) einen PSM-Verstärker umfasst.

11. Rundfunksender nach einem der vorangegangenen Ansprüche, dadurch gekennzeichnet, dass der Phasenrechner (23) aus den Abtastwerten des zyklischen Abtasters (21) entweder durch Klippung oder durch Nullstellendetektion ein Phasensignal erzeugt.

12. Rundfunksender nach einem der vorangegangenen Ansprüche, dadurch gekennzeichnet, dass die Phasenaufbereitung (10) im wesentlichen einen Frequenzumsetzer umfasst.

## Claims

1. Amplitude-modulated radio transmitter (1) comprising

a) a signal input (2) for at least one LF signal to be transmitted,

b) a signal conditioning means (11) with at least one input channel and two outputs, the input of the signal conditioning means being connected to the signal input and at the first output (24) of the signal conditioning means is supplied an amplitude signal, whilst at the second output (25) a phase signal is supplied,

c) a direct current-coupled power amplifier (9), placed behind the first output, for the amplification of the amplitude signal,

d) a phase conditioning means (10) for processing the phase signal positioned behind the second output,

e) and an output stage with a transmitting valve (5), which has an anode (4) and at least one control grid (3), the output of the power amplifier being connected to the anode (4) and the output of the phase conditioning means to the at least one control grid (3),

characterized in that for implementing different modulation types, particularly DSB (Double Side-Band), SSB (Single Side-Band) and ISB (Independent Side-Band), with a single transmitter,

f) the signal conditioning means (11) has two input channels (7a, b) and comprises

aa) an adder (16) and a subtracter (17), which form the sum or difference of the input channels (7a, b),

bb) a Hilbert transformer (12), whose input is either connected to the adder (16) or substracter (17) output and which subjects the sum or difference to a Hilbert transformation,

cc) two inverters (19, 20), whose inputs are connected to the outputs of either the adder (16) or the subtracter (17), as well as the Hilbert transformer (12) and whereby said inverters (19, 20) reverse the sign of the signals at their inputs,

dd) a cyclic scanner (21), which cyclically scans in a specific order the outputs of the inverters (19, 20) and either the adder (16) or subtracter (17), as well as the Hilbert transformer (12),

ee) a phase calculator (23), whose input is connected to the output of the cyclic scanner (21) and whose output is connected to the phase output (25), said phase calculator generating from the scan values of the cyclic scanner a phase signal,

ff) an amplitude calculator (22), which is connected by its two inputs to the output of either the adder (16) or the subtracter (17), as well as the Hilbert transformer (12) and in each case squares and summates the input signals (a, b) and extracts the root therefrom and delivers said signal at its output, which is connected to the amplitude output (24) and

g) the modulation type is fixed by a specific association of the LF signals (NF1, NF2) to be transmitted with the two input channels (7a, 7b).

2. Radio transmitter according to claim 1, characterized in that

a) for ISB two independent LF signals (NF1, NF2) are connected to the two input channels (7a, b),

b) for DSB two identical LF signals are connected to the two input channels (7a, b) and

c) for SSB a LF signal is connected to only one input channel (e.g. 7a) whereas the other input channel (7b) is connected to earth.

3. Radio transmitter according to claim 2, characterized in that the inputs (±a, ±b) of the cyclic scanner (21) are scanned in the order a, b, -a, -b or a, -b, -a, b.

4. Radio transmitter according to claim 3, characterized in that the signal conditioning means (11) additionally comprises

a) a carrier input (8),

b) a second adder (26), whose first input is connected to the output of the adder (16) and whose output is connected to the cyclic scanner (21) and the amplitude calculator (22) and

c) a carrier control, whose input is connected to the carrier input (8) and whose output is connected to the second input of the adder (26), in which

d) following the adder (16), the carrier (T) is added by means of the second adder (26).

5. Radio transmitter according to claim 4, characterized in that the added carrier (T) is controlled in the carrier control (14) in accordance with a carrier control characteristic as a function of the modulation factor.

6. Radio transmitter according to one of the preceding claims, characterized in that the signal conditioning means (11) additionally comprises

a) a four-pole changeover switch (13), in each case two inputs being coupled to an input pair and the first input pair is connected to the output of the Hilbert transformer (12) or the adder (16), and whose outputs are connected to the inputs of the cyclic scanner (21),
b) an input channel (27) for a further signal (PHI),
c) a phase modulation conditioning means (15), whose input is connected to the additional input channel (27), and whose outputs are connected to the second input pair of the changeover switch (13).

7. Radio transmitter according to claim 6, characterized in that in the case of DSB, provided that the signal amplitude is always lower than the carrier, for the transmission of an additional information

a) the changerover switch (13) is connected in such a way that the outputs of the phase modulation conditioning means (15) are connected through to the cyclic scanner and
b) the phase signal occurring in the cyclic scanner is phase-modulated by the phase modulation conditioning means.

8. Radio transmitter according to claim 7, characterized in that the input signals of the cyclic scanner (21) are scanned by the angle I at times t1, t2, t3, t4 for producing a sudden phase shift of a phase shift-keyed signal and at said points the scan values are:

at t1 : cos $\Phi$,
at t2 : sin $\Phi$,
at t3 : -cos $\Phi$,
at t4 : -sin $\Phi$.

9. Radio transmitter according to one of the preceding claims, characterized in that the order of the adder (16) and subtracter (17) and the Hilbert transformer (12) are interchanged, an independent Hilbert transformer being provided for each input channel.

10. Radio transmitter according to one of the preceding claims, characterized in that the direct current-coupled power amplifier (9) comprises a PSM amplifier.

11. Radio transmitter according to one of the preceding claims, characterized in that the phase calculator (23), either by clipping or by zero detection, generates a phase signal from the scan values of the cyclic scanner (21).

12. Radio transmitter according to one of the preceding claims, characterized in that the phase conditioning means (10) essentially comprises a frequency converter.

**Revendications**

1. Emetteur de radiodiffusion (1) modulé en amplitude comprenant

a) une entrée de signal (2) pour au moins un signal BF à transmettre;
b) une édition de signal (11) avec au moins une voie d'entrée et deux sorties, l'entrée de l'édition de signal étant reliée à l'entrée de signal, et la première sortie (24) émettant un signal d'amplitude alors que la seconde sortie (25) émet un signal de mise en phase;
c) un amplificateur de puissance (9) connecté à la tension continue, disposé derrière la première sortie et destiné à amplifier le signal d'amplitude;
d) une exécution de phase (10) disposée derrière la seconde sortie et destinée au traitement du signal de mise en phase; et
e) un étage final avec un tube émetteur (5) pourvu d'une anode (4) et d'au moins une grille de commande (3), la sortie de l'amplificateur de puissance étant reliée à l'anode (4) et la sortie de l'exécution de phase à au moins une grille de commande (3); caractérisé en ce qu'à des fins de réalisation de différents types de modulation, DBL (Double Bande Latérale), BLU (Bande Latérale Unique) et BLI (Bande Latérale Indépendante) notamment, avec un seul émetteur,
f) l'édition de signal (11) présente deux voies d'entrée (7a,b) et comprend

aa) un additionneur (16) et un circuit de soustraction (17), lesquels font respectivement la somme ou la différence des voies d'entrée (7a,b);

bb) un transformateur de Hilbert (12) dont l'entrée est reliée à la sortie soit de l'additionneur (16), soit du circuit de soustraction (17), et qui soumet la somme ou la différence à une transformation hilbertienne;

cc) deux inverseurs (19, 20) dont les entrées sont reliées aux sorties (a, b) de l'additionneur (16) ou du circuit de soustraction (17) ainsi que du transformateur de Hilbert (12), lesquels inversent le signe des signaux situés à leurs entrées,

dd) un explorateur (21) cyclique, lequel explore cycliquement et dans un certain ordre les sorties des inverseurs (19, 20) et soit celles de l'additionneur (16), soit celles du circuit de soustraction (17) ainsi que celles du transformateur de Hilbert (12);

ee) un calculateur de phase (23), lequel génère un signal de mise en phase à partir des valeurs d'analyse données par l'explorateur cyclique (21), dont l'entrée est reliée à la sortie de ce dernier et la sortie avec la sortie de phase (25);

ff) un calculateur d'amplitude (22) relié par ses deux entrées à la sortie soit de l'additionneur (16), soit du circuit de soustraction (17) ainsi qu'à celle du transformateur de Hilbert (12), lequel calcule le carré respectif des signaux d'entrée (a, b), les additionne avant d'en extraire la racine, puis émet ce signal à sa sortie reliée à la sortie d'amplitude (24); et en ce que

g) le type de modulation est défini en fonction de la manière donnée dont sont affectés à l'une des deux voies d'entrée (7a, 7b) les signaux BF (NF1, NF2) à transmettre.

**2.** Emetteur de radiodiffusion selon la revendication 1 caractérisé en ce que

a) pour la modulation BLI, on connecte aux deux voies d'entrée (7a,b) deux signaux BF (NF1, NF2) indépendants l'un de l'autre;

b) pour la modulation DBL, on connecte deux mêmes signaux BF aux deux voies d'entrée (7a,b); et en ce que

c) pour la modulation BLU, on ne connecte un signal BF qu'avec une seule voie d'entrée (par exemple 7a) alors que l'autre voie d'entrée (correspondant à 7b) est mise à la masse.

**3.** Emetteur de radiodiffusion selon la revendication 2 caractérisé en ce que les entrées (±a, ±b) de l'explorateur cyclique (21) sont analysées dans l'ordre a, b, -a, -b ou a, -b, -a, b.

**4.** Emetteur de radiodiffusion selon la revendication 3 caractérisé en ce que l'édition de signal (11) comprend en outre

a) une entrée de porteuse (8),

b) un second additionneur (26) dont la première entrée est reliée à la sortie de l'additionneur (16) et la sortie connectée à l'explorateur cyclique (21) et au calculateur d'amplitude (22), et

c) une commande pour porteuse dont l'entrée est reliée à l'entrée de porteuse (8) et la sortie à la seconde entrée de l'additionneur (26),

d) la porteuse (T) étant additionnée en aval de l'additionneur (16), au moyen du second additionneur (26).

**5.** Emetteur de radiodiffusion selon la revendication 4 caractérisé en ce que la porteuse (T) additionnée est asservie dans la commande pour porteuse (14) conformément à une courbe caractéristique de commande, en fonction d'un coefficient de modulation.

**6.** Emetteur de radiodiffusion selon l'une des revendications précédentes caractérisé en ce que l'édition de signal (11) comprend en outre

a) un commutateur quadripolaire (13), sur lequel deux entrées sont toujours couplées pour former une paire d'entrée, la première paire étant reliée à la sortie du transformateur de Hilbert (12) ou de l'additionneur (16), et dont les sorties sont raccordées aux entrées de l'explorateur cyclique (21);

b) une voie d'entrée (27) pour un autre signal (PHI);

c) une exécution de modulation de phase (15) dont l'entrée est reliée à la voie d'entrée (27) supplémentaire et les sorties à la seconde paire d'entrée du commutateur (13).

**7.** Emetteur de radiodiffusion selon la revendication 6 caractérisé en ce que, pour la modulation en DBL, dans la mesure où l'amplitude du signal est toujours inférieure à la porteuse et de manière à transmettre une information supplémentaire,

a) le commutateur (13) est placé de façon à ce que les sorties de l'exécution de modulation de phase (15) soient en connexion avec l'explorateur cyclique et

b) le signal de mise en phase généré dans l'explorateur cyclique subit une modulation de phase au moyen de l'exécution de modulation de phase.

8. Emetteur de radiodiffusion selon la revendication 7 caractérisé en ce que les signaux d'entrée de l'explorateur cyclique (21) sont analysés aux alentours de l'angle $\Phi$ aux moments t1, t2, t3, t4 où les valeurs d'analyse sont égales à

pour t1: cos$\Phi$
pour t2: sin$\Phi$
pour t3: -cos$\Phi$
pour t4: -sin$\Phi$,

ce de manière à générer un déphasage inconstant d'un signal ayant été soumis à une modulation par déplacement.

9. Emetteur de radiodiffusion selon l'une des revendications précédentes caractérisé en ce qu'on a interverti l'ordre dans lequel sont disposés l'additionneur (16) ou le circuit de soustraction (17) et le transformateur de Hilbert (12), un transformateur de Hilbert propre étant prévu pour chaque voie d'entrée.

10. Emetteur de radiodiffusion selon l'une des revendications précédentes caractérisé en ce que l'amplificateur de puissance (9) connecté à la tension continue comprend un amplificateur PSM.

11. Emetteur de radiodiffusion selon l'une des revendications précédentes caractérisé en ce que le calculateur de phase (23) génère un signal de mise en phase soit par écrêtage, soit par détection des zéros, sur la base des valeurs d'analyse de l'explorateur cyclique (21).

12. Emetteur de radiodiffusion selon l'une des revendications précédentes caractérisé en ce que l'exécution de phase (10) comprend essentiellement un convertisseur de fréquence.

*FIG.1*

*FIG.2*

FIG.3a

FIG.3b

FIG.3c

FIG.4

FIG.5a

FIG.5b

a   b   -a   -b   a   b   -a   -b   a   ...

sin(phi)

cos(phi) ...

1

cos(phi)

-1

-cos(phi)

-sin(phi)

FIG.6

FIG.7